(19) Europäisches Patentamt
European Patent Office
Office européen des brevets

(11) **EP 3 745 475 B1**

## (12) EUROPEAN PATENT SPECIFICATION

(45) Date of publication and mention
of the grant of the patent:
**06.03.2024 Bulletin 2024/10**

(21) Application number: **19177112.0**

(22) Date of filing: **28.05.2019**

(51) International Patent Classification (IPC):
**H01L 27/15** *(2006.01)*          **H01L 25/075** *(2006.01)*
**H01L 33/40** *(2010.01)*          **H01L 33/44** *(2010.01)*
**H01L 33/20** *(2010.01)*

(52) Cooperative Patent Classification (CPC):
**H01L 25/0753; H01L 27/156; H01L 33/405;**
H01L 33/20; H01L 33/44; H01L 2933/0016

---

(54) **A METHOD OF PRODUCING AN ARRAY OF MICRO-LEDS**

VERFAHREN ZUR HERSTELLUNG EINES ARRAYS VON MIKRO-LEDS

PROCÉDÉ DE FABRICATION D'UN RÉSEAU DE MICRO-DELS

---

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(43) Date of publication of application:
**02.12.2020 Bulletin 2020/49**

(73) Proprietor: **OSRAM Opto Semiconductors GmbH
93055 Regensburg (DE)**

(72) Inventor: **Ebbecke, Jens
93352 Helchenbach (DE)**

(74) Representative: **SJW Patentanwälte
Goethestraße 21
80336 München (DE)**

(56) References cited:
**US-A1- 2016 172 514     US-A1- 2018 090 539
US-A1- 2018 198 047**

---

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

**Description**

The present invention relates to a method of producing an array of micro-LEDs.

Micro-LEDs may be regarded as microscopic LEDs which may be used to form, for example, individual pixel elements in a display or the like. Micro-LED displays usually offer better contrast, response times, and energy efficiency when compared to LCD technology.

Such micro-LEDs are known from US 2018/0198047. An LED subpixel is provided with a reflector layer that controls viewing angles. After formation of an array of nanowires including first conductivity type cores and active layers, a second conductivity type semiconductor layer, a transparent conductive oxide layer, and a dielectric material layer are sequentially formed. Similar structures are known from US 2018/0090539 and also from US 2016/0172514.

It is an object of the present invention to provide an improved method of producing an array of micro-LEDs.

The object is satisfied by a method of producing an array of micro-LEDs in accordance with the features of claim 1. Preferred embodiments of the present invention are disclosed in the dependent claims.

A micro-LED as described herein comprises a layered structure with a first doped layer, a second doped layer, and an active layer between the first doped layer and the second doped layer, wherein the layered structure has sidewalls extending between an upper surface and a lower surface of the layered structure and forming an outer boundary of at least the first doped layer, the second doped layer, and the active layer, wherein the upper surface extends over the first doped layer and the lower surface extends below the second doped layer, wherein a first insulating layer is arranged on the upper surface and a second insulating layer is arranged on the sidewalls, wherein the first insulating layer has a through-opening at the upper surface, wherein over the first insulating layer, a conductive layer is disposed which protrudes into the opening such that the conductive layer is in contact with the upper surface, and wherein the conductive layer covers the second insulating layer.

In the micro-LED, the conductive layer might be arranged on the first insulating layer and might extend into the through-opening of the first insulating layer on the upper surface such that it is in contact with the upper surface. Therefore, the conductive layer can electrically contact the first doped layer which is arranged below the upper surface. The conductive layer might therefore serve as a contact for electrically contacting the first doped layer.

The first doped layer might be a p-doped layer and the second doped layer might be an n-doped layer. Thus, the conductive layer might serve as an electric p-contact for electrically contacting the p-doped layer.

As may become clearer from the method described below, the first insulating layer can be deposited, in particular by use of a material beam that provides the material for the conductive layer, on the first insulating layer. The conductive layer can therefore be formed in a simple way, in particular in comparison to a lithographic process that might also be used to form an electric contact on the first insulating layer such that the contact electrically contacts the first doped layer.

The layered structure of the micro-LED may in particular have a mesa form. The upper surface above the first doped layer and the lower surface below the second doped layer may each have a quadratic or rectangular form, with four sidewalls extending between the upper surface and the lower surface. The layered structure may in particular have outwardly tapered sidewalls when seen from the upper surface towards the lower surface.

In the micro-LED, the conductive layer also covers the second insulating layer. The conductive layer may partially cover the second insulating layer. In particular, the conductive layer may not cover a bottom part of the second insulating layer that is adjacent to the lower surface. As the conductive layer partly covers the second insulation layer on the sidewalls, the conductive layer can act as a mirror on the sidewalls. The conductive layer on the sidewalls can therefore cause a reduction in the loss of light through the sidewalls. A coupling out of the light through the upper surface may thereby be improved.

The conductive layer may be formed by any metallic material that is suitable to form an electric contact with a doped layer. In particular, the conductive material may be gold or silver.

The material used for the first and second insulating layers may be aluminum oxide ($Al_2O_3$). The material might have been deposited on the upper surface and the sidewalls by use of an atomic layer deposition process. The first and second layer may therefore be ALD-layers (ALD for Atomic Layer Deposition).

The through-opening in the first insulating layer may be centered on the upper surface.

The terms "between", "over", "above", and "below" as used herein may refer to a relative position of one layer or surface with respect to other layers as surfaces. For example, the expression that the upper surface extends over/above the first doped layer may be understood in the sense that the upper surface is directly over/above the first doped layer. In particular, the upper surface can be the surface provided by the first doped layer, or it can be the surface of another layer that is arranged above the first doped layer. Moreover, one layer "between" layers may be directly in contact with the layers or may have one or more intervening layers.

The terms "micro"-LED or "array of micro-LEDs" as used herein may refer to the descriptive size of certain devices or structures in accordance with embodiments of the invention. As used herein, the terms "micro"-LEDs or structures are meant to refer to the scale of 1 to 100 um. However, it is to be appreciated that embodiments of the present invention are not necessarily so limited, and that certain aspects of the embodiments may be applicable to larger, and possibly smaller size scales.

The conductive layer can be disposed over the first insulating layer such as to completely cover the first insulating layer and/or the opening. Thereby, a proper electric contact with the first doped layer can be ensured.

In some embodiments, the conductive layer is disposed over the second insulating layer such as to completely cover a portion of the second insulating layer which is above the first insulating layer and the active layer. Thus, the conductive layer may completely cover the portion of the second insulating layer which covers on the sidewalls the first doped layer and the active layer. The second insulating layer is electrically nonconductive. Therefore, the conductive layer cannot create a shortcut on the sidewalls of the micro-LED's layered structure. However, the conductive layer can act as an effective mirror avoiding a loss of light through the sidewalls.

Moreover, the conductive layer is in substance at the electric potential of the electric contact which is electrically connected to the first doped layer. For example, if the first doped layer is a p-doped layer, the electric potential is usually at a few volts in the positive. The conductive layer may create a potential difference on the sidewalls with respect to the underlying active layer. This is in particular the case when the conductive layer covers the portion of the second insulating layer which is above the active layer on the sidewalls. This potential difference pushes electric carriers, such as holes, from the boundary region of the active layer towards the central region of the active layer. Thereby, non-emitting losses that may occur at the boundary of the active layer may be reduced.

In some embodiments, the conductive layer is disposed over the second insulating layer such as to partly cover a portion of the second insulating layer which is above the second doped layer. The conductive layer may extend on the sidewalls from the top of the layered structure towards the bottom of the layered structure such that it partly covers the second insulating layer which is placed above the second doped layer. However, the conductive layer may be distal from the lower surface. A portion of the second layer which is adjacent the lower surface and which circumferentially surrounds the sidewalls is therefore not covered by the conductive layer. Thus, the conductive layer does not reach the bottom of the layered structure. The layered structure usually comprises a substrate on which the lower surface is arranged. As the conductive layer covers the sidewalls but remains distal from the lower surface, the conductive layer does not get into contact with the substrate. Thereby, an electric shortcut between the conductive layer and, for example, a conductive surface on the substrate can be avoided.

The conductive layer may be a continuous layer. There may be no openings arranged in the conductive layer. The conductive layer can therefore be manufactured in a simple way, for example, via vapor deposition.

The upper surface may be formed by the topside of the first doped layer. Thus, there may be no additional layer between the first doped layer and the upper surface. Correspondingly, the lower surface may be formed by the bottom side of the second doped layer.

In some embodiments, the first insulating layer is integrally formed with the second insulating layer. The insulating layers can therefore be formed in one process.

The first insulating layer might completely cover the upper surface. However, there may be arranged a central through-opening at the upper surface for contacting the underlying first doped layer.

The second insulating layer might completely cover the sidewalls. The second insulating layer may therefore electrically isolate the underlying sides of the first doped layer, the active layer, and the second doped layer.

The second insulating layer might also cover a topside of a substrate on which the micro-LED resides.

The active layer may include a quantum well. A variety of single quantum well or multiple quantum well configurations may be utilized to form the quantum well.

An array of micro-LEDs as described herein may comprise a substrate, and a plurality of micro-LEDs, wherein the micro-LEDs form an array-like arrangement on a topside of the substrate, and wherein the lower surface of each micro-LED is arranged on the topside of the substrate. A micro-LED may be obtained from a process of separating the array of micro-LEDs into individual micro-LEDs.

In some embodiments, a pitch between neighboring micro-LEDs is 5 um, 10 um or larger.

In some embodiments, each micro-LED has a quadratic or rectangular upper surface, wherein the quadratic or rectangular upper surface has a width of 2 $\mu$m or 3 um or 4 $\mu$m or 5 um or larger.

In some embodiments, neighboring micro-LEDs are separated from each other by a spacing of 1 $\mu$m or 2 $\mu$m or 3 um or 4 $\mu$m or 5 um or larger.

In some embodiments, each micro-LED has a height extending from the upper surface to the lower surface. The height may at least approximately be 2 $\mu$m, 3 $\mu$m, 4 $\mu$m, 5 um or larger.

The present invention relates to a method of producing an array of micro-LEDs. The method comprises the steps of:

Providing an array of micro-LEDs in accordance with at least some embodiments as described herein, but where the micro-LEDs do not have the conductive layer on each micro-LED of the array of micro-LEDs.

Depositing the conductive layer on the micro-LEDs of the array of micro-LEDs, wherein the step of depositing the conductive layer comprises:

Exposing the array of micro-LEDs to a material beam comprising the material to form the conductive layer, wherein the material beam has a beam direction, and wherein the array of micro-LEDs is disposed in the material beam such that the micro-LEDs face the material beam, and wherein a surface normal is perpendicular to the topside of the substrate, and wherein the surface normal and the beam direction form an angle which is unequal to 0°.

The array of micro-LEDs may be arranged in such a way that the topside of the substrate is inclined with respect to the beam direction. The micro-LEDs of the array of micro-LEDs usually have four sidewalls. Due to the inclination of the array of micro-LEDs with respect to the beam direction, a sidewall of a micro-LED can be partially exposed to the incident beam, while neighboring micro-LEDs prevent a complete exposure of the sidewall to the material beam. The conductive layer can not only be built-up on top of the first insulating layer which covers the upper surface of each micro-LED's layered structure, but the conductive layer can also be built up on the second insulating layer which covers the sidewall. Due to the short pitch between neighboring micro-LEDs, the neighboring micro-LEDs may partly protect a sidewall of a micro-LED from exposure to the material beam. In particular, a bottom portion of the sidewall that is adjacent to the lower surface of the corresponding micro-LED will not be exposed to the material beam. Thus, in this lower portion, no conductive layer builds up. This lower portion usually corresponds to the part of the sidewall which covers the second doped layer. Thereby, it can be ensured that the conductive layer does not reach down to the substrate. The creation of electric shortcuts can thereby be prevented.

As mentioned before, each micro-LED has preferably four sidewalls. To ensure that each sidewall is exposed to the incident material beam, the array of micro-LEDs is preferably rotated to expose each sidewall to the material beam. The rotation of the array of micro-LEDs preferably takes place in such a way that the angle of inclination of the substrate with respect to the beam direction does not change. The rotation may be a continuous rotation or a stepwise rotation. Each sidewall of the micro-LEDs might be exposed for a predetermined amount of time to the material beam.

The step of rotating the array of micro-LEDs may comprise the following steps:

rotating the array of micro-LEDs such that one of the sidewalls is facing the material beam,
holding the array of micro-LEDs in this position for a predetermined amount of time, then rotating the array of micro-LEDs such that another sidewall is facing the material beam,
holding the array of micro-LEDs in the respective position for the predetermined amount of time, and
repeating the above-described process until all four sidewalls were exposed to the material beam for the predetermined amount of time.

The angle of inclination of the top side of the substrate with respect to the beam direction is preferably in the range of 40 to 70° or of 50 to 60°.

Neighboring micro-LEDs of the array of micro-LEDs may be separated by a spacing x and, after application of the conductive layer, the conductive layer may cover the second insulating layer such that the second insulating layer has a height h on the sidewalls. The angle of inclination α is then **,** in accordance with the invention, approximately calculated by use of the following formula:

$$\alpha \; = \; 90° \; - \; \tan^{-1}\left(\frac{h}{x}\right).$$

The space x is measured between neighboring sidewalls and between two facing sidewalls of the two neighboring micro-LEDs. The height h is measured from the upper-side of a micro-LED towards the bottom side of the micro-LED.

The invention is described in the following by way of example and with reference to the accompanying drawings in which:

Fig. 1 shows schematically a side view of a portion of an array of micro-LEDs, wherein the array of micro-LEDs is exposed to a material beam, and
Fig. 2 shows schematically a cross-sectional view of a portion of an array of micro-LEDs.

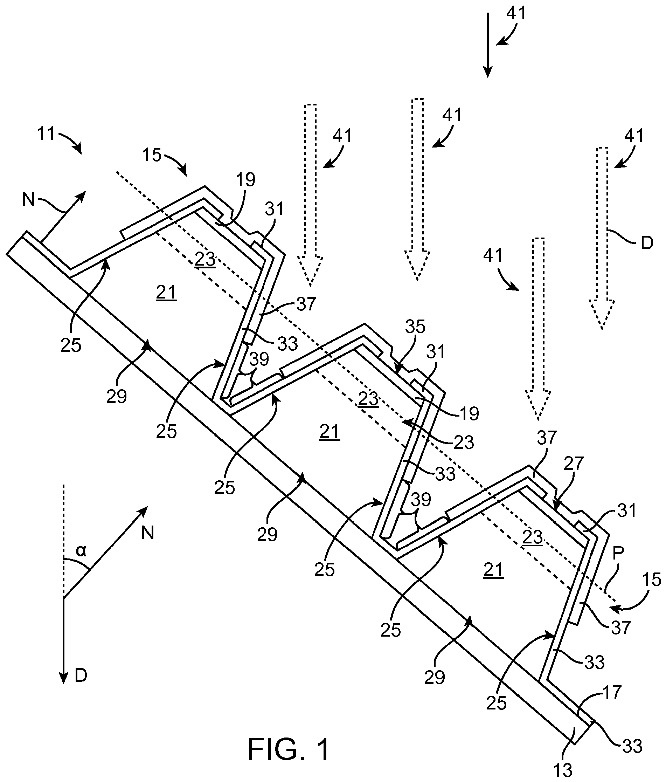

The array of micro-LEDs 11 as shown in Fig. 1 comprises a substrate 13, and a plurality of micro-LEDs 15 arranged on the substrate 13. The micro-LEDs 15 form an array-like arrangement on a topside 17 of the substrate 13.

Each micro-LED 15 comprises a layered structure with a first doped layer 19, a second doped layer 21, and an active layer 23 between the first doped layer 19 and the second doped layer 21. The layered structure has four sidewalls 25 extending between an upper surface 27 and a lower surface 29 of the layered structure and forming an outer boundary of at least the first doped layer 19, the second doped layer 21, and the active layer 23. In other words, the lateral end surfaces of the first doped layer 19, the second doped layer 21, and the active layer 23 may form the sidewalls 25.

The upper surface 27 extends over the first doped layer 19 and corresponds in the shown example to the upper side of the first doped layer 19. In other examples, at least one additional layer may be arranged on top of the first doped layer 19, so that the upper surface 27 may be part of another layer.

The lower surface 29 extends below the second doped layer 21 and corresponds in the shown example to the bottom side of the second doped layer 21. In other examples, at least one additional layer may be arranged below the second doped layer 21, so that the lower surface 29 may be part of another layer. The lower surface 29 is in abutment with the topside 17 of the substrate 13.

A first insulating layer 31 is arranged on the upper surface 27, and a second insulating layer 33 is arranged on the sidewalls 25. The second insulating layer 33 may also cover the topside 17 of the substrate 13. The first and second insulating layers 31, 33 may form one uniform layer that completely covers the upper surface 27, the sidewalls 25 and the topside 17.

However, the first insulating layer 31 has a central through opening 35 which provides access to the first doped layer 19.

Over the first insulating layer 31, a conductive layer 37 is disposed which protrudes into the opening 35 such as to contact the upper surface 27 of the first doped layer 19. The conductive layer 37 may completely cover the opening 35.

The conductive layer 37 partly covers the second insulating layer 33 as shown in Fig. 1. The conductive layer 37 is a continuous layer, so that the portion of the conductive layer that covers the second insulating layer 33 might be integrally formed with the portion of the conductive layer 37 that covers the first insulating layer 31.

The conductive layer 37 is disposed over the second insulating layer 33 such as to cover completely an upper portion of the second insulating layer 33. This upper portion covers the lateral faces of the first doped layer 19, of the active layer 23, and of an upper part of the second doped layer 19. This is also illustrated in Fig. 1 by showing a central plane P that extends through the center cross-sectional area of the respective active regions 23.

A lower portion 39 of the second insulating layer 33 is not covered by the conductive layer 37. The lower portion 39 extends around the sidewalls 25 in the circumferential direction which is parallel to the topside 17. The conductive layer 37 is therefore distal from the lower surface 29 of the layered structure of the micro-LEDs 15, and the conductive layer 37 is not in contact with the topside 17 of the substrate 13.

The array of micro-LEDs 11 can be provided in such a way that the conductive layer 37 is not yet present on the micro-LEDs 15 of the array of micro-LEDs 11. The process of producing the conductive layer 37 on the micro-LEDs 15 of the array of micro-LEDs 11 will be described in more detail below.

In accordance with an exemplary method, a step of depositing the conductive layer 37 on the micro-LEDs 15 of the array of micro-LEDs 11 comprises exposing the array of micro-LEDs 11 to a material beam 41 which comprises the material, such as gold or silver, for the conductive layer 37. The material beam 41 is incident along a beam direction D. The array of micro-LEDs 11 is disposed in the material beam 41 such that the micro-LEDs 15 face the material beam 41. However, as shown in Fig. 1, the array of micro-LEDs 11 is inclined with respect to the beam direction.

In particular, the inclination is such that a surface normal N, which is perpendicular to the topside 17 of the substrate 13, and the beam direction D form an angle $\alpha$ which is unequal to zero degrees. The angle $\alpha$ might be, for example, in the range between 40 and 70 degrees or between 50 and 60 degrees.

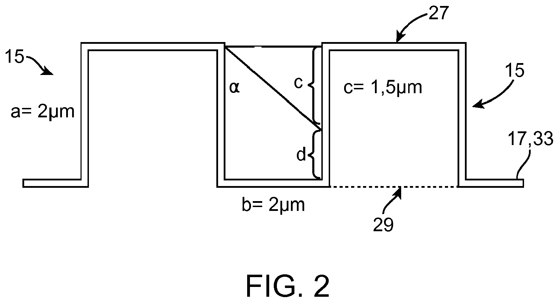

Z |B In accordance with the invention, the angle of inclination $\alpha$ is determined in the following way and as illustrated with reference to Fig. 2. Neighboring micro-LEDs 15 of the array of micro-LEDs 11 are assumed to be separated from each other by a spacing b, for example b = 2 um. Furthermore, after application of the conductive layer 37, the conductive layer 37 is assumed to cover the second insulating layer 33 such that the conductive layer 37 has a height c on the sidewalls 25. The height c is measured from the upper surface 27 in the direction towards the lower surface 29. For example, c = 1,5 um.

The total height a of the sidewalls might be a = 2 $\mu$m. The inclination angle $\alpha$ is calculated by use of the following formula:

$$\alpha = 90° - \tan{-1}\ (c/b) \approx 53°.$$

Thus, when the surface normal N is inclined by an angle $\alpha$ of about 53° with respect to the surface normal N, a lower portion 39 of the second insulating layer with a height d of about 0,5 $\mu$m (measured from the lower surface 29 towards the upper surface 27) will not be covered by the conductive layer 37. This is in particular due to a shielding effect provided by neighboring micro-LEDs 15 to a sidewall 25 of a micro-LED 15. The lower portion 39 of the sidewall 25 is in the shadow of a neighboring micro-LED 15 when exposed to the incident beam 41. Thus, no beam material can accumulate on this bottom portion 39.

As a micro-LED 15 has typically four sidewalls, the step of depositing the conductive layer 37 on the micro-LEDs 15 of the array of micro-LEDs 11 might include rotating the array of micro-LEDs 11 while keeping the angle $\alpha$ constant. This may, for example, be achieved by rotating the array of micro-LEDs 11 around the center axis of the substrate 13 which is parallel to the surface normal N.

The array of micro-LEDs 11 may preferably be rotated such as to expose each of the four sidewalls 25 of the micro-LEDs 15 for at least a predetermined period of time to the material beam 41. This may be achieved by a continuous rotation or by a step-wise rotation.

Using a step-wise rotation, the array of micro-LEDs 11 is rotated to a position as indicated in Fig. 1, such that a sidewall 25 of the micro-LEDs 15 is exposed to the material beam 41 for a predetermined period of time. The position is then changed such that another sidewall 25 of the micro-LEDs 15 is exposed to the incident material beam 41 for the period of time. The process is repeated until all four sidewalls 25 of the micro-LEDs 15 were exposed to the incident material beam 41.

Each micro-LED 15 might have a quadratic upper surface 27, for example, with a width of 2 $\mu$m or 3 $\mu$m or 4 $\mu$m or 5 um or larger. Neighboring micro-LEDs 15 might be separated by a spacing of 1 $\mu$m or 2 $\mu$m or 3 $\mu$m or 4 $\mu$m or 5 $\mu$m. Each micro-LED 15 might further have a total height (measured from the upper surface 27 to the lower surface 29 of the respective micro-LED 15) of 2 $\mu$m, 3 $\mu$m, 4 $\mu$m, 5 um or larger.

The conductive layer 37 can be produced in a simple way on the micro-LEDs 15 of the array of micro-LEDs 11, in particular by use of the material beam 41. This lithography-free process is easy to implement considering the very small dimensions of a micro-LED 15. The conductive layer 37 may further serve to contact electrically the first doped layer 19, which can for example be a p-doped layer 19. The second doped layer 21 can be contacted electrically via a conductor on the topside 17 of the substrate 13. Moreover, the conductive layer 37 on the sidewalls 25 may provide a mirror effect and thus reduce the loss of light through the sidewalls 25. Due to the electric potential on the conductive layer 37, electric carriers in the active layer 23 might be driven to the center of the active layer 23 and away from the lateral faces of the active layer 23. This may help to reduce non-radiative losses in the layered structure.

**LIST OF REFERENCE SIGNS**

| | |
|---|---|
| 11 | array of micro LEDs |
| 13 | substrate |
| 15 | micro-LED |
| 17 | top side of substrate |
| 19 | first doped layer |
| 21 | second doped layer |
| 23 | active layer |
| 25 | sidewalls |
| 27 | upper surface |
| 29 | lower surface |
| 31 | first insulating layer |
| 33 | second insulating layer |
| 35 | through opening |
| 37 | conductive layer |
| 39 | lower portion |
| 41 | material beam |
| D | beam direction |
| N | surface normal |
| P | center plane of active zone |
| $\alpha$ | angle |
| a | total height |
| b | spacing |
| c | height |
| d | height |

**Claims**

1. A method of producing an array of micro-LEDs (11), the method comprises the step of:
   providing an array of micro-LEDs (11) comprising:

   a substrate (13), and
   a plurality of micro-LEDs (15), wherein the micro-LEDs (15) form an array-like arrangement on a topside (17)

of the substrate (13), and
wherein a lower surface (29) of each micro-LED (15) is arranged on the topside (17) of the substrate (13), wherein each micro-LED (15) comprises:

a layered structure with a first doped layer (19), a second doped layer (21), and an active layer (23) between the first doped layer (19) and the second doped layer (21),
wherein the layered structure has sidewalls (25) extending between an upper surface (27) and a lower surface (29) of the layered structure and forming an outer boundary of at least the first doped layer (19), the second doped layer (21), and the active layer (23),
wherein the upper surface (27) extends above the first doped layer (19) and the lower surface (29) extends below the second doped layer (21),
wherein a first insulating layer (31) is arranged on the upper surface (27) and a second insulating layer (33) is arranged on the sidewalls (25),
wherein the first insulating layer (31) has a through opening (35) at the upper surface (27),
the method further comprises the step of:

depositing a conductive layer (37) on each of the micro-LEDs (15) of the array of micro-LEDs (11), such that the conductive layer (37) is disposed over the first insulating layer (31) and protrudes into the opening (35) and contacts the upper surface (27) and such that the conductive layer (37) covers the second insulating layer (33),
wherein the step of depositing the conductive layer (37) comprises:

exposing the array of micro-LEDs to a material beam (41) comprising material for forming the conductive layer (37),
wherein the material beam (15) has a beam direction (D), and wherein the array of micro-LEDs (11) is disposed in the material beam (41) such that the micro-LEDs (15) face the material beam (41), wherein a surface normal (N) is perpendicular to the topside (17) of the substrate (13), and wherein the surface normal (N) and the beam direction (D) include an angle ($\alpha$);
wherein neighboring micro-LEDs (15) of the array of micro-LEDs (11) are separated by a spacing x, wherein, after application of the conductive layer (37), the conductive layer (37) covers the second insulating layer (33) such that the conductive layer (37) has a height h on the sidewalls (25),

**characterised in that** the angle ($\alpha$) is not zero degrees, and **in that** the angle ($\alpha$) is approximately calculated by use of the following formula:

$$\alpha = 90° - \tan^{-1}(h/x).$$

2. The method in accordance with claim 1,
wherein the angle ($\alpha$) is in the range between 40 and 70 degrees or between 50 and 60 degrees.

3. The method in accordance with any one of the preceding claims,

wherein the step of depositing the conductive layer (37) on the micro-LEDs (15) of the array of micro-LEDs (11) includes:
rotating the array of micro-LEDs (11) while keeping the angle ($\alpha$) at least approximately constant.

4. The method in accordance with claim 3,
wherein each micro-LED (15) comprises four sidewalls (25), wherein the array of micro-LEDs (11) is rotated such as to expose each of the sidewalls (25) for at least a predetermined period of time to the material beam (41).

**Patentansprüche**

1. Verfahren zur Herstellung einer Anordnung von Mikro-LEDs (11), wobei das Verfahren die folgenden Schritte umfasst:
Bereitstellen eines Arrays von Mikro-LEDs (11), umfassend:

ein Substrat (13), und

eine Vielzahl von Mikro-LEDs (15), wobei die Mikro-LEDs (15) eine arrayartige Anordnung auf einer Oberseite (17) des Substrats (13) bilden, und

wobei eine untere Fläche (27) jeder Mikro-LED (15) auf der Oberseite (17) des Substrats (13) angeordnet ist, wobei jede Mikro-LED (15) umfasst:

eine Schichtstruktur mit einer ersten dotierten Schicht (19), einer zweiten dotierten Schicht (21), und einer aktiven Schicht (23) zwischen der ersten dotierten Schicht (19) und der zweiten dotierten Schicht (21)
wobei die Schichtstruktur Seitenwände (25) aufweist, die sich zwischen einer oberen Oberfläche (27) und einer unteren Oberfläche (29) der Schichtstruktur erstrecken und eine äußere Begrenzung von mindestens der ersten dotierten Schicht (19), der zweiten dotierten Schicht (21) und der aktiven Schicht (23) bilden,
wobei sich die obere Fläche (27) oberhalb der ersten dotierten Schicht (19) und die untere Fläche (29) unterhalb der zweiten dotierten Schicht (21) erstreckt,
wobei auf der Oberseite (27) eine erste Isolierschicht (31) und an den Seitenwänden (25) eine zweite Isolierschicht (33) angeordnet ist,
wobei die erste Isolierschicht (31) eine Durchgangsöffnung (35) an der Oberseite (27) aufweist,
das Verfahren ferner den folgenden Schritt umfasst:

Abscheiden einer leitenden Schicht (37) auf jeder der Mikro-LEDs (15) des Arrays von Mikro-LEDs (11), so dass die leitende Schicht (37) über der ersten isolierenden Schicht (31) angeordnet ist und in die Öffnung (35) hineinragt und die obere Oberfläche (27) berührt und so dass die leitende Schicht (37) die zweite isolierende Schicht (33) bedeckt,
wobei der Schritt des Aufbringens der leitenden Schicht (37) umfasst:

Aussetzen des Arrays von Mikro-LEDs einem Materialstrahl (41), der Material zur Bildung der leitenden Schicht (37) enthält, wobei der Materialstrahl (15) eine Strahlrichtung (D) hat, und wobei die Anordnung von Mikro-LEDs (11) in dem Materialstrahl (41) so angeordnet ist, dass die Mikro-LEDs (15) dem Materialstrahl (41) zugewandt sind,
wobei eine Oberflächennormale (N) senkrecht zur Oberseite (17) des Substrats (13) ist, und wobei die Oberflächennormale (N) und die Strahlrichtung (D) einen Winkel (α) einschließen, der nicht null Grad beträgt;
wobei benachbarte Mikro-LEDs (15) der Anordnung von Mikro-LEDs (11) durch einen Abstand x getrennt sind,
wobei die leitende Schicht (37) nach dem Aufbringen der leitenden Schicht (37) die zweite isolierende Schicht (33) so bedeckt, dass die leitende Schicht (37) eine Höhe h an den Seitenwänden (25) aufweist, und
wobei der Winkel (α) näherungsweise mit Hilfe der folgenden Formel berechnet wird:

$$\alpha = 90° - \tan^{-1}(h/x).$$

2. Verfahren nach Anspruch 1,
wobei der Winkel (α) im Bereich zwischen 40 und 70 Grad oder zwischen 50 und 60 Grad liegt.

3. Verfahren nach einem der vorhergehenden Ansprüche,
wobei der Schritt des Aufbringens des leitfähigen Layers (37) auf die Mikro-LEDs (15) des Arrays von Mikro-LEDs (11) umfasst:
Drehen des Arrays von Mikro-LEDs (11), wobei der Winkel (α) zumindest annähernd konstant gehalten wird.

4. Verfahren nach Anspruch 3,
wobei jede Mikro-LED (15) vier Seitenwände (25) umfasst, wobei die Anordnung von Mikro-LEDs (11) so gedreht wird, dass jede der Seitenwände (25) für mindestens eine vorbestimmte Zeitspanne dem Materialstrahl (41) ausgesetzt wird.

**Revendications**

1. Méthode de production d'un réseau de micro-LEDs (11), la méthode comprend l'étape de :
fournir un réseau de micro-LEDs (11) comprenant :

> un substrat (13), et
> une pluralité de micro-LED (15), dans laquelle les micro-LED (15) forment un arrangement en forme de réseau sur une face supérieure (17) du substrat (13), et

dans lequel une surface inférieure (27) de chaque micro-LED (15) est disposée sur la face supérieure (17) du substrat (13), dans lequel chaque micro-LED (15) comprend :

> une structure en couches avec une première couche dopée (19), une deuxième couche dopée (21), et une couche active (23) entre la première couche dopée (19) et la deuxième couche dopée (21), dans laquelle la structure en couches possède des parois latérales (25) s'étendant entre une surface supérieure (27) et une surface inférieure (29) de la structure en couches et formant une limite extérieure d'au moins la première couche dopée (19), la seconde couche dopée (21) et la couche active (23),
> dans laquelle la surface supérieure (27) s'étend au-dessus de la première couche dopée (19) et la surface inférieure (29) s'étend sous la deuxième couche dopée (21),
> dans laquelle une première couche isolante (31) est disposée sur la surface supérieure (27) et une seconde couche isolante (33) est disposée sur les parois latérales (25),
> dans laquelle la première couche isolante (31) présente une ouverture de passage (35) sur la surface supérieure (27),
> le procédé comprend en outre l'étape consistant à :
> déposer une couche conductrice (37) sur chacune des micro-DEL (15) du réseau de micro-DEL (11), de telle sorte que la couche conductrice (37) soit disposée sur la première couche isolante (31) et fasse saillie dans l'ouverture (35) et entre en contact avec la surface supérieure (27) et de telle sorte que la couche conductrice (37) recouvre la deuxième couche isolante (33), dans lequel l'étape de dépôt de la couche conductrice (37) comprend :

>> l'exposition de la matrice de micro-LEDs à un faisceau de matériaux (41) comprenant des matériaux pour former la couche conductrice (37),
>> dans lequel le faisceau de matériau (15) a une direction de faisceau (D), et dans lequel le réseau de micro-LEDs (11) est disposé dans le faisceau de matériau (41) de telle sorte que les micro-LEDs (15) font face au faisceau de matériau (41),
>> dans lequel une normale de surface (N) est perpendiculaire à la face supérieure (17) du substrat (13), et dans lequel la normale de surface (N) et la direction du faisceau (D) comprennent un angle ($\alpha$) qui n'est pas de zéro degré ;
>> dans lequel les micro-LED voisines (15) du réseau de micro-LED (11) sont séparées par un espacement x,
>> dans lequel, après application de la couche conductrice (37), la couche conductrice (37) recouvre la seconde couche isolante (33) de telle sorte que la couche conductrice (37) présente une hauteur h sur les parois latérales (25), et
>> dans lequel l'angle ($\alpha$) est approximativement calculé à l'aide de la formule suivante :

$$\alpha = 90° - \tan^{-1}(h/x).$$

2. La méthode selon la revendication 1,
dans laquelle l'angle ($\alpha$) est compris entre 40 et 70 degrés ou entre 50 et 60 degrés.

3. La méthode selon l'une des revendications précédentes,
dans lequel l'étape de dépôt de la couche conductrice (37) sur les micro-LEDs (15) de la matrice de micro-LEDs (11) comprend :
la rotation du réseau de micro-LEDs (11) en maintenant l'angle ($\alpha$) au moins approximativement constant.

4. La méthode selon la revendication 3,
dans laquelle chaque micro-LED (15) comprend quatre parois latérales (25), dans laquelle le réseau de micro-LED (11) est tourné de manière à exposer chacune des parois latérales (25) pendant au moins une période de temps prédéterminée au faisceau de matériau (41).

FIG. 1

FIG. 2

**EP 3 745 475 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20180198047 A
- US 20180090539 A
- US 20160172514 A